# DEMANDE DE BREVET EUROPEEN

(11) **EP 1 096 681 A1**
(43) Date de publication de la demande: **02.05.2001**
(21) Numéro de dépôt: 00410129.1
(22) Date de dépôt: 27.10.2000
(51) Int. Cl.: H03K 17/10

(54) **Commutateur très haute tension**

(30) Priorité: 28.10.1999 FR 9913752
(71) Demandeur: Pixtech S.A., 13790 Rousset (FR)
(72) Inventeur: Bancal, Bernard, 13080 Luynes (FR); Peyron, Philippe, 13100 Palette-le Tholonet (FR)
(74) Mandataire: de Beaumont, Michel

(57) **Abrégé**

L'invention concerne un commutateur de type push-pull, comprenant un premier transistor MOS à canal N (M1) dont le trajet drain-source est connecté entre une borne de tension haute (10) et une borne de sortie (13), une première résistance (20) connectée entre la grille du premier transistor et la tension haute, une diode (D) dont l'anode est reliée à la borne de sortie (13) et dont la cathode est reliée à la grille du premier transistor, un deuxième transistor MOS à canal N (M2) dont le drain est connecté à la cathode de la diode, la source à un potentiel de référence, et la grille à une borne de commande, et une deuxième résistance (40) connectée entre la grille du deuxième transistor et la borne de sortie (13).

## Description

La présente invention concerne un commutateur très haute tension et plus particulièrement un commutateur de type push-pull.

Dans l'art antérieur, les commutateurs de type push-pull contiennent de façon générale des transistors de types complémentaires, à savoir des transistors bipolaires de type NPN et de type PNP ou des transistors MOS à canal N et à canal P. Ceci ne permet pas de choisir des composants optimaux quand on veut fabriquer des commutateurs haute tension.

D'autre part, de façon classique, quand on veut obtenir des commutateurs très haute tension, on cherche à utiliser des composants pouvant supporter une tension aussi élevée que possible et ceci entraîne la nécessité de fabriquer des composants spécifiques à coûts élevés.

Un premier objet de la présente invention est de prévoir un commutateur de type push-pull dans lequel tous les transistors soient de même type.

Un autre objet de la présente invention est de prévoir un tel commutateur susceptible de supporter des tensions très élevées.

Pour atteindre ces objets, la présente invention prévoit un commutateur de type push-pull comprenant un premier transistor MOS à canal N dont le trajet drain-source est connecté entre une borne de tension haute et une borne de sortie, une première résistance connectée entre la grille du premier transistor et la tension haute, une diode dont l'anode est reliée à la borne de sortie et dont la cathode est reliée à la grille du premier transistor, un deuxième transistor MOS à canal N dont le drain est connecté à la cathode de la diode, la source à un potentiel de référence, et la grille à une borne de commande, et une deuxième résistance connectée entre la grille du deuxième transistor et la borne de sortie.

Selon un mode de réalisation de la présente invention, chacun des transistors MOS a sa source reliée à son substrat.

Selon un mode de réalisation de la présente invention, une troisième résistance est disposée en série avec la grille du deuxième transistor, la deuxième borne de cette troisième résistance étant reliée à la deuxième résistance et à une diode de protection dont la deuxième borne est reliée à la borne de référence.

Selon un mode de réalisation de la présente invention, chacun des premier et deuxième transistors est remplacé par une chaîne de transistors en série, et chacune des première et deuxième résistances est remplacée par une chaîne correspondante de résistances, les résistances de chacune des chaînes étant égales entre elles, des quatrième résistances égales entre elles étant connectées entre les grilles des transistors reliés au potentiel haut et des cinquième résistances étant reliées entre les grilles des transistors reliées à la tension basse.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un premier mode de réalisation de la présente invention ; et
la figure 2 représente un deuxième mode de réalisation de la présente invention.

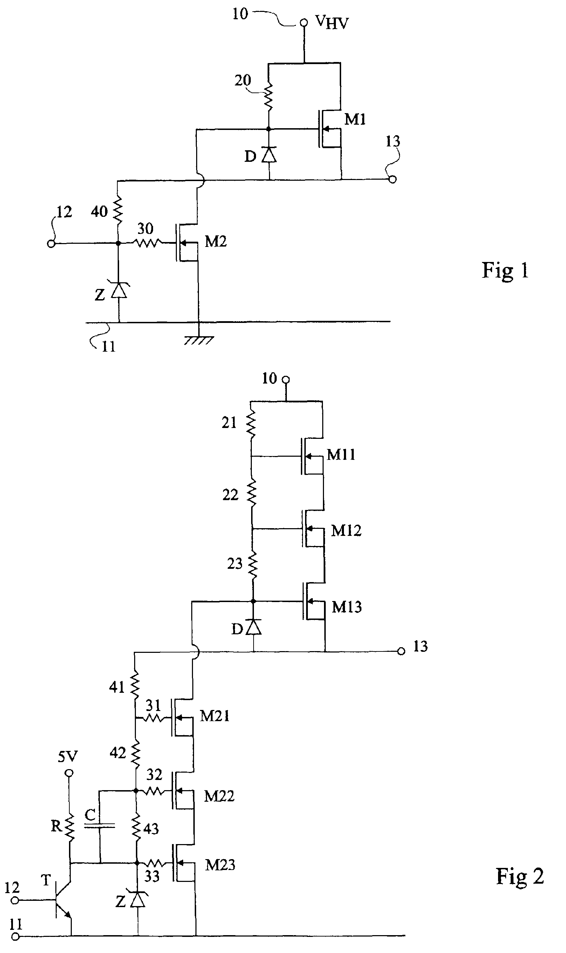

La figure 1 représente un circuit de commutation de type push-pull qui, selon un avantage de la présente invention, comporte seulement des transistors MOS haute tension de même type. Le circuit est connecté entre une borne haute tension 10, une borne de potentiel de référence 11, couramment la masse, une borne de commande 12, et une borne de sortie 13.

Entre la borne haute tension 10 et la borne de sortie 13 est disposé un premier transistor MOS à canal N M1 dont la grille est relié à la borne 10 par une résistance 20 et à la source par l'intermédiaire d'une diode D. L'anode de la diode est reliée à la source du transistor M1 et sa cathode à la grille. La cathode de la diode D est également reliée à la borne de référence 11 par l'intermédiaire d'un deuxième transistor MOS à canal N M2. La grille du transistor M2 est connectée à une première borne d'une résistance 30. La deuxième borne de la résistance 30 est connectée à la borne de commande 12, à la borne de référence 11 par l'intermédiaire d'une diode de protection Z, et à la borne de sortie 13 par l'intermédiaire d'une résistance 40. Les résistances 30 et 40 sont des résistances de polarisation de valeurs élevées et les transistors M1 et M2 ont tous les deux leurs substrats reliés à leurs sources.

Le fonctionnement de ce circuit est le suivant. Supposons que dans un état initial le transistor M1 est passant et le transistor M2 bloqué, la borne de commande 12 étant à niveau bas. Alors, la borne de sortie 13 est à une valeur de tension élevée. Si on considère que la grille du transistor M1 est sensiblement à la valeur du potentiel élevé de la borne 10 (V_{HV}), le potentiel sur la borne 13 est V_{HV}-V_{T}, V_{T} étant la tension de seuil du transistor M1. La consommation induite est négligeable si le dispositif est un dispositif haute tension mais basse puissance. Quand on applique un signal de commande à niveau haut à la borne 12, ceci tend à rendre passant le transistor M2. En conséquence, la diode D devient passante et la tension entre source et grille du transistor M1 devient égale à la chute de tension en direct (V_{F}) de la diode D. Le transistor M1 est alors polarisé en inverse et se bloque. En conséquence, la borne de sortie 13 est reliée à la borne 11 par la diode D et le transistor M2. Le potentiel de sortie devient sensiblement égal à V_{F}. En effet, on peut négliger la chute de tension aux bornes du transistor M2, ce transistor étant alors équivalent à une résistance de valeur très faible devant la résistance 20.

Le circuit décrit précédemment présente l'avantage de constituer un commutateur push-pull avec des transistors de puissance M1 et M2 de même type : ce sont tous deux des transistors MOS à enrichissement à canal N et à source connectée au substrat. Ceci permet de choisir des transistors identiques, rapides et pouvant supporter des tensions élevées. Le système présente aussi l'avantage d'être commandé par une instruction unique sur la borne 12.

Selon un autre aspect de la présente invention, un schéma du type de celui de la figure 1 est utilisé pour répartir les tensions entre plusieurs transistors MOS à canal N. D'où il résulte que, pour commuter par exemple une tension de 3000 V, on pourra utiliser trois transistors pouvant supporter une tension de 1000 V dans chacune des branches du commutateur push-pull.

La figure 2 représente un exemple d'un tel schéma. Le circuit de la figure 2, comme le circuit de la figure 1, est connecté entre des bornes de haute tension 10, de référence 11, de commande 12 et de sortie 13. Le transistor M1 est remplacé par une chaîne de trois transistors M11, M12, M13. La grille du transistor M11 est connectée à la borne 10 par une résistance 21, la grille du transistor M12 est connectée à la grille du transistor M11 par une résistance 22. La grille du transistor M13 est connectée à la grille du transistor M12 par une résistance 23. Une diode D est connectée par son anode à la source du transistor M13 (borne 13) et par sa cathode à la grille du transistor M13. La cathode de la diode D est également connectée à une chaîne de transistors M21 à M23 qui remplacent le transistor M2. Chacun des transistors M21, M22, M23 a sa grille connectée à une première borne d'une résistance de polarisation 31, 32, 33. La deuxième borne de la résistance 31 est reliée à la borne 13 par une résistance 41, la deuxième borne de la résistance 32 est connectée à la grille du transistor M21 par une résistance 42 et la deuxième borne de la résistance 33 est connectée à la grille du transistor M22 par une résistance 43. Une diode de protection Z est connectée entre grille et source du transistor M23.

De préférence un condensateur C est disposé en parallèle sur la résistance de polarisation inférieure 43 et la commande est appliquée sur la borne 12 par l'intermédiaire d'un inverseur comprenant une résistance R dont une première borne est connectée à une tension haute (de l'ordre de 5 V) et dont la deuxième borne est connectée au collecteur d'un transistor T dont l'émetteur est connecté à la borne 11 et la base à la borne 12.

Le fonctionnement du circuit de la figure 2 est similaire à celui de la figure 1. La connexion en série des transistors M11 à M13 étant associée à une chaîne de résistances de polarisation de grille de mêmes valeurs 21 à 23, les potentiels se répartissent également entre ces transistors sans que l'on risque de dépasser une tension de claquage (drain-source, drain-grille ou source-grille) de l'un de ces transistors. De même, les transistors M21 à M23 étant associés à des résistances de polarisation de mêmes valeurs 41 à 43, les tensions se répartissent également entre ces transistors. Ainsi, aucun des transistors M11 à M13 et aucun des transistors M21 et M23 n'est susceptible de supporter une tension supérieure au tiers de la tension d'alimentation.

Plus en détail, si on suppose que la borne 13 est initialement à tension haute, c'est-à-dire que le signal de commande sur la borne 12 est à niveau haut, de sorte que le collecteur du transistor T et la grille du transistor M23 sont à niveau bas, les transistors M21 à M23 sont bloqués et les transistors M11 à M13 sont passants. Comme précédemment, la borne 13 se trouve au potentiel haut V_{HV} moins la tension de seuil V_{T} du transistor M13. Quand on ramène à zéro le signal sur la borne 12, la grille du transistor M23 se polarise à niveau haut et ce transistor tend à devenir passant. En raison de l'existence de la chaîne de résistances 41-43, la même tension apparaît aux bornes des transistors M21-M23 et ces trois transistors deviennent simultanément progressivement passants. Alors, la diode D devient conductrice et, comme précédemment, le transistor M13 tend à se bloquer ce qui entraîne le blocage des transistors M11 et M12, les mêmes tensions grille-source apparaissant sur chacun de ces transistors en raison de l'existence de la chaîne de résistances 21, 22, 23.

On a indiqué précédemment que les trois résistances 21 à 23 sont égales de même que les trois résistances 41 à 43. Ces résistances sont de préférence choisies élevées pour réduire la consommation statique du commutateur. Toutefois, pour augmenter la vitesse à la commutation à la mise à zéro, on pourra diminuer la valeur des résistances 41 à 43. De même pour augmenter la vitesse de commutation à la mise à niveau haut, on pourra diminuer la valeur des résistances 21 à 23.

Dans un exemple de réalisation, les six transistors étaient des transistors MOS à canal N à enrichissement dont chacun supportait une tension de 1000 V. Les résistances 21 à 23 et 41 à 43 étaient toutes égales à 1,6 MΩ. En ce cas, on a obtenu un temps de montée de l'ordre de 150 µs et un temps de descente de l'ordre de 50 µs.

Un avantage de la présente invention est que, comme le comprendra l'homme de l'art, le nombre de transistors peut être augmenté ou diminué. Pour supporter des tensions de 5000 V, on pourra par exemple prévoir sans inconvénients une chaîne de cinq transistors MOS à canal N dans chacune des branches du commutateur push-pull, chacun de ces transistors pouvant supporter 1000 V.

Le circuit selon la présente invention est susceptible de diverses variantes et modifications qui apparaîtront à l'homme de l'art. Par exemple, la prévision d'un condensateur C en parallèle sur la résistance 43 est optionnelle.

## Revendications

1. Commutateur de type push-pull, caractérisé en ce qu'il comprend :
un premier transistor MOS à canal N (M1) dont le trajet drain-source est connecté entre une borne de tension haute (10) et une borne de sortie (13),
une première résistance (20) connectée entre la grille du premier transistor et la tension haute,
une diode (D) dont l'anode est reliée à la borne de sortie (13) et dont la cathode est reliée à la grille du premier transistor,
un deuxième transistor MOS à canal N (M2) dont le drain est connecté à la cathode de la diode, la source à un potentiel de référence, et la grille à une borne de commande, et
une deuxième résistance (40) connectée entre la grille du deuxième transistor et la borne de sortie (13) .

2. Commutateur push-pull selon la revendication 1, caractérisé en ce que chacun des transistors MOS a sa source reliée à son substrat.

3. Commutateur push-pull selon la revendication 1, caractérisé en ce qu'une troisième résistance (30) est disposée en série avec la grille du deuxième transistor, la deuxième borne de cette troisième résistance étant reliée à la deuxième résistance et à une diode de protection (Z) dont la deuxième borne est reliée à la borne de référence.

4. Commutateur push-pull selon la revendication 1, caractérisé en ce que chacun des premier et deuxième transistors est remplacé par une chaîne de transistors en série (M11-M13 ; M21-M23), et en ce que chacune des première et deuxième résistances est remplacée par une chaîne correspondante de résistances, les résistances de chacune des chaînes étant égales entre elles, des quatrième résistances (41, 42, 43) égales entre elles étant connectées entre les grilles des transistors reliés au potentiel haut, et des cinquième résistances (51, 52, 53) étant reliées entre les grilles des transistors reliées à la tension basse.
